# EUROPEAN PATENT APPLICATION

(11) **EP 4 790 488 A1**
(43) Date of publication of application: **12.08.2026**
(21) Application number: 24874619.0
(22) Date of filing: 01.10.2024
(51) Int. Cl.: G03F 9/00, G03F 7/20

(54) **DETERMINATION METHOD, PATTERN TRANSFER METHOD, ARTICLE MANUFACTURING METHOD, PROGRAM, INFORMATION PROCESSING DEVICE, AND LITHOGRAPHY SYSTEM**

(30) Priority: 03.10.2023 JP 2023172129
(71) Applicant: Canon Kabushiki Kaisha, Tokyo 146-8501 (JP)
(72) Inventor: KAJITANI, Masaharu, Tokyo 146-8501 (JP)
(74) Representative: TBK
(86) International application number: PCT/JP2024/035171
(87) International publication number: WO 2025/075018

(57) **Abstract**

A determination method includes a generation step of generating correction measurement data by removing a component dependent on an array of a plurality of shot regions of a first substrate onto which a pattern is transferred by a lithography apparatus from measurement data of the first substrate; and a determination step of determining a correction value to be provided to the lithography apparatus when transferring a pattern onto a second substrate by using the lithography apparatus based on the correction measurement data and an array of a plurality of shot regions of the second substrate.

## Description

### TECHNICAL FIELD

The present invention relates to a determination method, a pattern transfer method, an article manufacturing method, a program, an information processing apparatus, and a lithography system.

### BACKGROUND ART

Recently, with higher integration and miniaturization of semiconductor integrated circuits, the linewidths of patterns formed on substrates have extremely decreased. With this tendency, further miniaturization is required in a lithography process for forming a resist pattern on a substrate. In a step-and-repeat exposure apparatus and a step-and-scan exposure apparatus, alignment between an original plate and a substrate is important. A general alignment method is a method (global alignment) of performing alignment by measuring the positions of alignment marks in several sample shot regions selected from a plurality of shot regions on a substrate and obtaining the array of the plurality of shot regions based on the measurement. Recently, in order to correct the nonlinear deformation of a substrate, a high-order shot array correction model and a high-order shot shape correction model are used. A main index for alignment results is overlay error. An overlay error indicates the relative positional shift between the layers formed in a lithography process. With higher integration and miniaturization of semiconductor integrated circuits, there are increasing demands for reduction in overlay error.

Factors that cause the nonlinear deformation of a substrate can include the characteristics of a substrate holding mechanism that holds a substrate in an exposure apparatus in addition to a lithography process and the like in forming a pattern on a substrate. The substrate holding mechanism is ideally configured to correct the deflection of a substrate caused by a lithography process to a flattened state. It is, however, difficult to correct, in particular, the outer peripheral region of a substrate to a flattened state, thus inevitably causing nonflatness. The occurrence of nonflatness will cause an error in the position measurement of an alignment mark provided in a shot region of the substrate, thus leading to a deterioration in overlay error as an alignment result between a previous layer and a new layer in a lithography process. In addition, the nonflatness of a substrate affects focus control as well as causing a deterioration in overlay error and hence leading to a deterioration in the resolution of the pattern formed on the substrate.

Japanese Patent No. 6630839 discloses a method of reducing an overlay deterioration and a focus deterioration with respect to the nonflatness of a substrate by determining the deflection amount of the substrate based on the characteristics of the substrate holding mechanism and calibrating alignment control.

Since the substrate holding mechanism repeatedly comes into contact with substrates over a long period of time, certain members deform and wear out due to collision at the time of holding a substrate and the pressure applied at the time of releasing a substrate. In addition, as demands for improvement in terms of overlay errors and focus requirements increase with higher integration and miniaturization of semiconductor integrated circuits, individual differences between substrate holding mechanisms cannot be ignored. Accordingly, there is a need to reduce the influences of local fine substrate deflection and substrate deflection caused by a substrate holding mechanism on alignment accuracy.

### SUMMARY OF INVENTION

The present invention provides a technique advantageous in improving the transfer accuracy of a pattern with respect to a substrate.

One aspect of the present invention is associated with a determination method. The determination method includes a generation step of generating correction measurement data by removing a component dependent on an array of a plurality of shot regions of a first substrate onto which a pattern is transferred by a lithography apparatus from measurement data of the first substrate and a determination step of determining a correction value to be provided to the lithography apparatus when transferring a pattern onto a second substrate by using the lithography apparatus based on the correction measurement data and an array of a plurality of shot regions of the second substrate.

Other features and advantages of the present invention will be apparent from the following description taken in conjunction with the accompanying drawings. Note that the same reference numerals denote the same or like components throughout the accompanying drawings.

### BRIEF DESCRIPTION OF DRAWINGS

The accompanying drawings, which are incorporated in and constitute a part of the specification, illustrate embodiments of the invention and, together with the description, serve to explain principles of the invention.
Fig. 1 is a view showing the configuration of an exposure apparatus according to one embodiment;
Fig. 2 is a view showing the configuration of a lithography system according to one embodiment;
Fig. 3 is a flowchart showing a determination method according to one embodiment;
Fig. 4 is a view exemplarily showing substrate measurement data;
Fig. 5 is a view exemplarily showing an error component unique to a shot layout;
Fig. 6 is a view exemplarily showing a step driving direction at the time of exposure processing;
Fig. 7 is a view exemplarily showing an error component occurring due to a step driving direction;
Fig. 8 is a view exemplarily showing a scan driving direction at the time of exposure processing;
Fig. 9 is a view exemplarily showing an error component occurring due to a scan driving direction;
Fig. 10 is a view exemplarily showing a determination method;
Fig. 11 is a view exemplarily showing shape correction for shot regions;
Fig. 12 is a view exemplarily showing periodic acquisition of the measurement data of a substrate;
Fig. 13A is a view exemplarily showing the variation in the density of measurement data of a substrate;
Fig. 13B is a view exemplarily showing the variation in the density of measurement data of a substrate;
Fig. 14A is a view exemplarily showing the interpolation of measurement data of a substrate; and
Fig. 14B is a view exemplarily showing the interpolation of measurement data of a substrate.

### DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

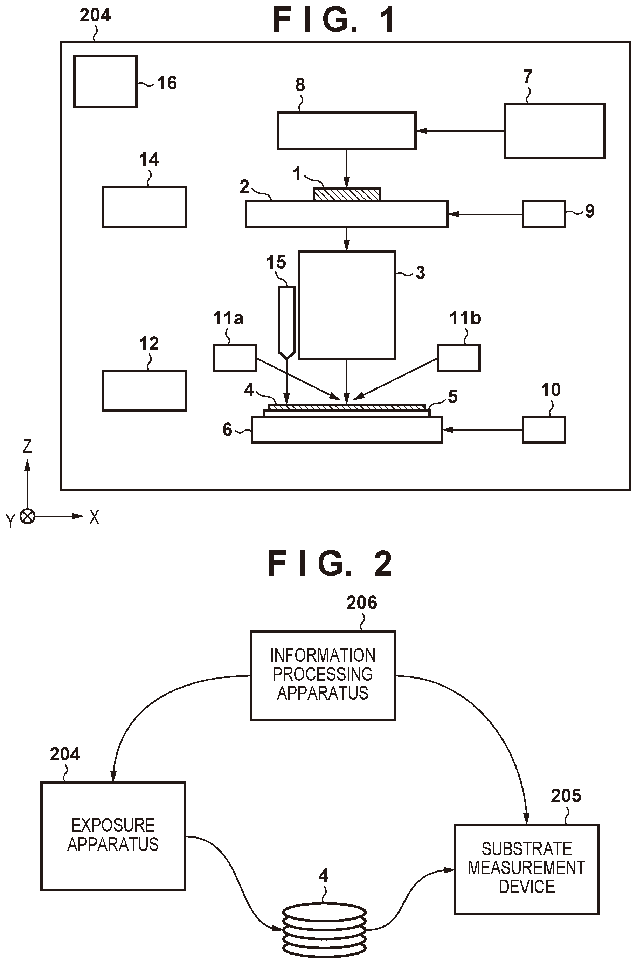

Fig. 1 is a view showing the configuration of an exposure apparatus 204 according to one embodiment. The exposure apparatus 204 is an example of a lithography apparatus or pattern transfer apparatus which transfers a pattern onto a substrate. A lithography apparatus or pattern transfer apparatus can be, for example, any one of an exposure apparatus, an imprint apparatus, and an electron beam drawing apparatus. Note that in this specification and the accompanying drawings, directions will be indicated in an XYZ coordinate system in which a surface (a horizontal plane in general) of a substrate 4 is an X-Y plane. Directions parallel to the X-axis, the Y-axis, and the Z-axis of the XYZ coordinate system are the X direction, the Y direction, and the Z direction, respectively. A rotation about the X-axis, a rotation about the Y-axis, and a rotation about the Z-axis are θX, θY, and θZ, respectively.

The exposure apparatus 204 can be configured as a step-and-scan exposure apparatus, that is, a scanning exposure apparatus (scanner), which exposes the substrate 4 to light while synchronously driving a reticle stage (original plate stage) and a substrate stage. The following is a description of a case where the exposure apparatus 204 is a scanning exposure apparatus. However, the exposure apparatus 204 is not limited to a scanning exposure apparatus and may be configured as a step-and-repeat exposure apparatus (stepper) that performs exposure while keeping the substrate stage stationary. The exposure apparatus 204 can include a light source 7, an illumination optical system 8, a reticle stage 2, a projection optical system 3, a substrate stage 6, a substrate holding mechanism 5, and a controller 16. The exposure apparatus 204 can include a laser interferometer 9, a laser interferometer 10, a focus sensor 11, a substrate transfer unit 12, a reticle transfer unit 14, and an alignment scope 15.

The light source 7 can be, for example, any one of a high-pressure mercury lamp, an ArF excimer laser, a KrF excimer laser, and an EUV light source. In addition, the light source 7 may be accommodated in the chamber of the exposure apparatus 204 or connected to the chamber. The light output from the light source 7 illuminates a reticle 1 (original plate) through the illumination optical system 8. The reticle 1 has a pattern to be transferred onto the substrate 4 coated with a photosensitive material and is placed on the reticle stage 2. The reticle stage 2 holds a reticle through a reticle holding mechanism (not shown) and is driven by a driving mechanism (for example, a linear motor) (not shown).

The projection optical system 3 projects the pattern of the reticle 1 onto the substrate 4 placed on the substrate holding mechanism 5. This will transfer the pattern of the reticle 1 onto the substrate 4 (its photosensitive material). In this case, the pattern of the reticle 1 is projected (transferred) onto the substrate 4 at the projection magnification (for example, 1/4) of the projection optical system 3. A region onto which the pattern of the reticle 1 is projected is called a shot region. A plurality of shot regions are set or defined on the substrate 4. Projection is performed on a plurality of shot regions in a preset sequence.

The substrate stage 6 can be driven in the X direction and the Y direction by, for example, a driving mechanism (linear motor) (not shown). The substrate holding mechanism 5 is mounted on the substrate stage 6 and holds the substrate 4. The substrate stage 6 can be configured to position the substrate holding mechanism 5 in the Z direction, the θZ direction, the θX direction, and the θY direction. The substrate 4 held by the substrate holding mechanism 5 is moved by driving of the substrate stage 6 and the substrate holding mechanism 5.

The laser interferometer 9 measures the position of the reticle stage 2 in the Y direction and measures the posture of the reticle stage 2. Likewise, the exposure apparatus 204 includes a laser interferometer (not shown) for measuring the position of the reticle stage 2 in the X direction. The laser interferometer 10 measures the position of the substrate stage 6 in the Y direction, on which the substrate 4 is placed, and measures the posture of the substrate stage 6. Likewise, the exposure apparatus 204 includes a laser interferometer (not shown) that measures the position of the substrate stage 6 in the X direction. The controller 16 controls the positions of the reticle stage 2 and the substrate stage 6 based on the positions measured by the laser interferometer 9 and the laser interferometer 10.

The focus sensor 11 can include a light projection system 11a that projects light (a plurality of beams) onto the substrate 4, a light reception system 11b that receives reflected light from the substrate 4, and a detection unit (not shown) that detects light from the light reception system 11b and outputs a detection signal to the controller 16. The light projection system 11a and the light reception system 11b are arranged to sandwich a portion near the exit portion of the projection optical system 3 so as to make the light projection system 11a irradiate a substrate with oblique incident light and make the light reception system 11b receive reflected light on the opposite side. The controller 16 detects the position of the substrate 4 in the Z direction based on the detection signal detected by the focus sensor 11 and controls the movement of the substrate 4 by the substrate stage 6.

The substrate transfer unit 12 transfers the substrate 4. The substrate transfer unit 12 transfers the substrate 4 from a substrate storage (not shown) which stores the substrate 4 or the like to the substrate stage 6. The substrate transfer unit 12 transfers the substrate 4 from the substrate stage 6 to the substrate storage or the like.

The reticle transfer unit 14 transfers the reticle 1. The reticle transfer unit 14 transfers the reticle 1 from a reticle storage (not shown) or the like storing the reticle 1 to the reticle stage 2. The reticle transfer unit 14 also transfers the reticle 1 from the reticle stage 2 to the reticle storage or the like.

The alignment scope 15 generates a digital image signal by capturing an image of a mark provided on the substrate 4 to perform positioning (alignment) of the substrate 4 held by the substrate holding mechanism 5. The alignment scope 15 can include an image sensor (not shown) that outputs a density image signal corresponding to the brightness of reflected light from the substrate 4, that is, density, and an A/D converter (not shown) that converts the density image signal obtained from the image sensor into a digital image signal. The controller 16 detects the position of a mark on the substrate 4 by using the digital image signal output from the alignment scope 15 and controls the substrate stage 6 based on the detected position of the mark, thereby positioning the substrate 4.

The controller 16 controls the processing of exposing the substrate 4 to light by controlling the operation, adjustment, and the like of each unit of the exposure apparatus 204. The controller 16 is, for example, an information processing apparatus that can be implemented by a PLD (the abbreviation of Programmable Logic Device) such as an FPGA (the abbreviation of Field Programmable Gate Array), an ASIC (the abbreviation of Application Specific Integrated Circuit) or a computer incorporating a program and a storage device or a combination of some or all of these. The controller 16 can be implemented by a plurality of information processing apparatuses. The controller 16 may be integrated with another part of the exposure apparatus 204 (in a common housing) or may be implemented independently of another part of the exposure apparatus 204 (in a different housing). The controller 16 can also perform control to execute exposure processing (lithography processing) on the substrate 4 by using the processing conditions acquired from a storage device or the like. The processing conditions used for exposure processing can include, for example, positioning conditions defining, for example, a tolerance at the time of positioning the substrate 4 with the substrate stage 6. The processing conditions used for exposure processing can also include measurement conditions defining the irradiation time of light, the irradiation timing, and the like at the time of measurement with the focus sensor 11. In addition, the processing conditions used for exposure processing can include, for example, exposure conditions defining the identifier of the reticle 1, the layout of a shot region on the substrate 4, an illumination mode, and the like at the time of exposure on the substrate 4. Furthermore, the processing conditions used for exposure processing can include setup conditions including environment conditions defining a temperature and an atmospheric pressure in the exposure apparatus and information such as the model of the exposure apparatus and a software version.

Fig. 2 is a view showing the configuration of a lithography system according to one embodiment. The lithography system according to one embodiment can include the exposure apparatus 204, a substrate measurement device 205 that measures the substrate 4 having undergone exposure processing by the exposure apparatus 204, and an information processing apparatus 206 that processes the measurement result obtained by the substrate measurement device 205. The substrate measurement device 205 can measure an overlay error which is an alignment result in the X and Y directions between a previous layer and a new layer thereon in a lithography process and also measure a pattern shape and pattern dimensions which are alignment results in the Z direction. An overlay error is measured by measuring the box-in-box marks constituted by the marks respectively formed on two layers as measurement targets.

The information processing apparatus 206 receives the measurement result obtained by the substrate measurement device 205, generates correction values for alignment based on the measurement result, and provides the correction values to the exposure apparatus 204. The correction values for alignment in the X and Y directions can include central correction values for the shot region in the X and Y directions, shape correction values for the shot region in the X and Y directions, and the like. The central correction values for the shot region and the shape correction values for the shot region can include nonlinear correction values. The correction values for alignment in the Z direction can include a rotation correction value θX around the X-axis and a rotation correction value θY around the Y-axis. The correction values for alignment in the Z direction may be determined for each position of the stage in the scanning direction during scanning exposure on one shot region in the step-and-scan exposure apparatus.

The exposure apparatus 204 can improve the alignment accuracy by storing correction values for alignment in the storage device of the controller 16 and reflecting the correction values in the control of the reticle stage 2 and the substrate stage 6 in exposure processing on the substrate 4. The information processing apparatus 206 can be implemented by a computer incorporating programs and a storage device or a combination of some or all of these. The programs can be provided to the information processing apparatus (computer) via a computer-readable memory medium, a data communication network, or the like.

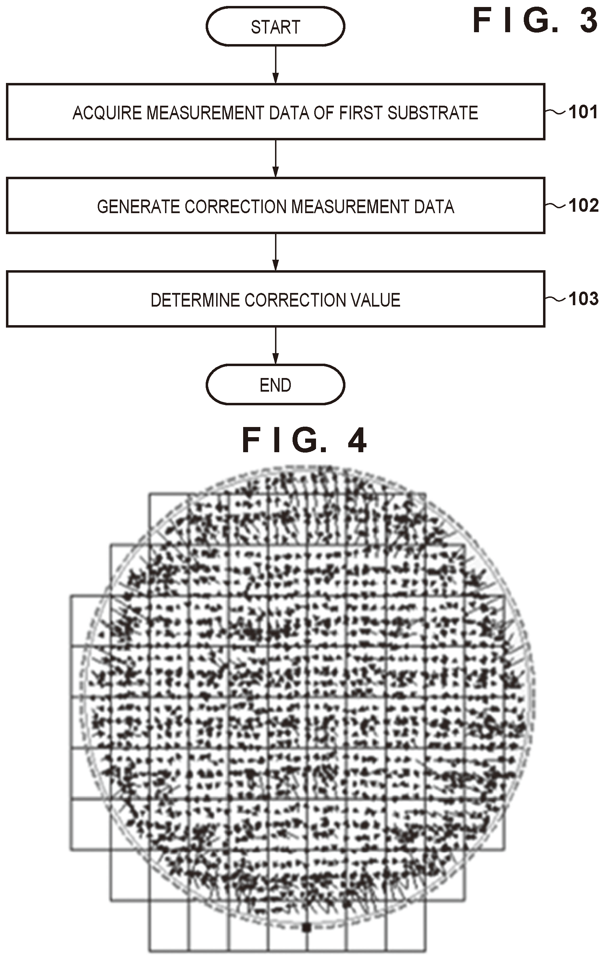

Fig. 3 is a flowchart showing a procedure in a determination method according to one embodiment. Although the following is a description of an example in which the information processing apparatus 206 executes the processing shown in Fig. 3, the exposure apparatus 204 (the controller 16) may execute the processing. Note that a shot layout is the array (layout) of a plurality of shot regions on a substrate. A substrate error component common to shot layouts is a substrate error component independent of a shot layout, in other words, a substrate error component common to a plurality of shot layouts that can be applied to exposure processing.

First of all, in step 101 (acquisition step), the information processing apparatus 206 acquires, for example, the measurement data of the first substrate from the substrate measurement device 205. The information processing apparatus 206 can be understood as an apparatus including an acquisition unit that executes step 101. The first substrate is a substrate onto which a pattern is transferred by the exposure apparatus 204 upon exposure processing like that described above, with the transferred pattern being developed by a developing device (not shown), that is, being converted into a physical pattern. A substrate as a material for the first substrate may be, for example, a substrate that is managed to correct the inter-apparatus differences between a plurality of exposure apparatuses, a substrate shipped out as a product, or another substrate. The first substrate has marks such as box-in-box marks for the measurement of an overlay error between two layers formed through exposure processing by the exposure apparatus 204. In order to acquire the overall characteristics of the first substrate without bias/uniformly, several tens of box-in-box marks are preferably arranged uniformly at a predetermined pitch (for example, 5 mm pitch) in the X and Y directions in each shot region. Reducing the arrangement pitch of box-in-box marks makes it possible to acquire more detailed substrate measurement data and to improve the correction accuracy of a substrate error component common to shot layouts. For example, as shown in Fig. 4, the measurement data of the first substrate can be data having measurement values in the X and Y directions at each point on the substrate.

In step 102 (generating step), the information processing apparatus 206 generates correction measurement data by removing a component dependent on the shot layout (the array of a plurality of shot regions) on the first substrate from the measurement data of the first substrate. The information processing apparatus 206 can be understood as an apparatus including a generating unit that executes step 102. In this case, the measurement data of the first substrate acquired in step 101 can include, for example, an error component caused by unique exposure processing by the exposure apparatus 204 as well as an error component due to the distortion of the substrate which occurs due to the characteristics of the substrate holding mechanism 5. The former, that is, the error component due to the distortion of the substrate which occurs due to the characteristics of the substrate holding mechanism 5 is a substrate error component common to shot layouts. In contrast to this, the latter, that is, the error component caused by unique exposure processing by the exposure apparatus 204 is an error component dependent on the shot layout in the exposure processing, that is, the error component unique to the shot layout. Accordingly, it is possible to approximately obtain a substrate error component common to shot layouts by removing an error component (an error component dependent on the shot layout) caused by unique exposure processing by the exposure apparatus 204 from the measurement data acquired in step 101.

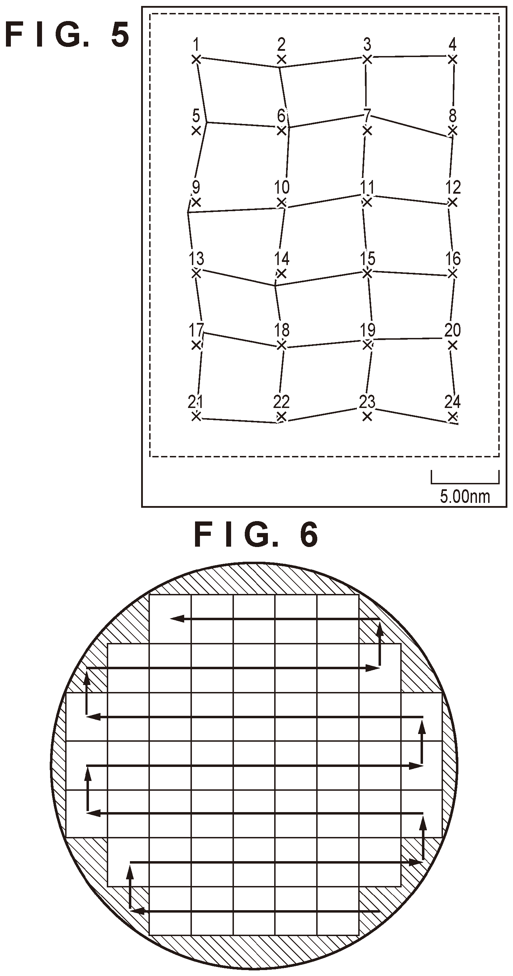

Fig. 5 exemplarily shows a shot common shape component which is one of the error components unique to the shot layout. The shot common shape component is a shape component common to a plurality of shot region on the substrate. A shot common shape component is mainly caused by the shape characteristic of the reticle 1, the drive characteristic of the reticle stage 2, the drive characteristic of the projection optical system 3, and the drive characteristic of the substrate stage 6. Fig. 5 shows an example of a shot common shape component in a case where four box-in-box marks and six box-in-box marks are respectively arranged in the X and Y directions in the shot region. Fig. 5 shows an example of obtaining the average value of measurement data in each of a plurality of shot regions by processing the measurement data of the first substrate. This value is obtained by calculating the average value of measurement data at the same coordinates in a plurality of shot regions. The example shown in Fig. 5 is the view obtained by connecting adjacent measurement data (average values) through straight lines.

In a case where there is no shape distortion common to a plurality of shot regions, lattices orthogonally intersect with each other. In a case where there is any shape distortion common to a plurality of shot regions, lattices do not orthogonally intersect with each other. Such a shot common shape component is removed from the measurement data of each shot region of the measurement data of the first substrate. This makes it possible to obtain correction measurement data indicating the substrate error component common to the shot layouts from which the error component unique to the shot layouts is removed.

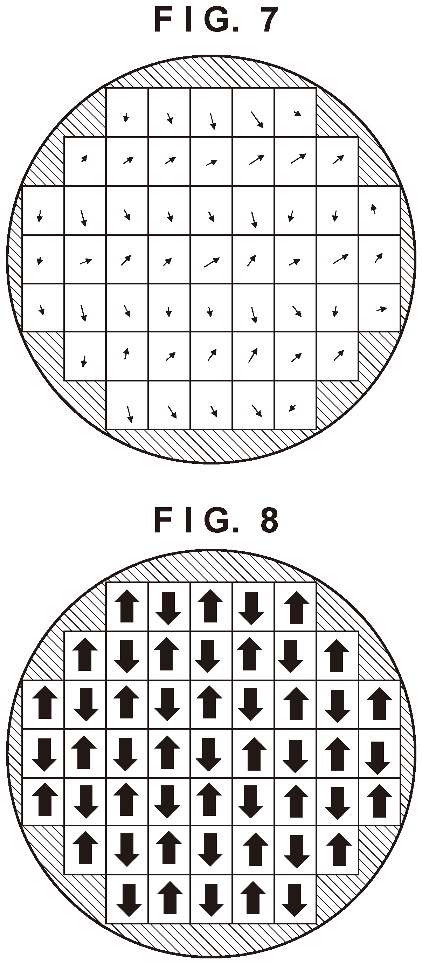

In addition, another error component unique to a shot layout occurs in the step driving direction of the substrate stage 6 between shot regions in the exposure apparatus 204. The substrate stage 6 is driven to place a shot region as an exposure target below the projection optical system 3 before exposure processing in the exposure apparatus 204. This operation is called step driving. Fig. 6 shows an example of a step driving direction at the time of exposure processing by the exposure apparatus 204. Fig. 7 shows an example of an error component occurring due to a step driving direction of the substrate stage 6, illustrating how a characteristic error component occurs due to the step driving direction. This error component is mainly caused by the drive characteristic of the substrate stage 6 and the characteristic of the laser interferometer 10. A step driving direction at the time of exposure processing is determined by a predetermined shot layout and a shot exposure sequence. For example, the memory device of the controller 16 holds information indicating a shot layout and a shot exposure sequence. A step driving direction at the time of exposure processing is provided based on the shot layout and the shot exposure sequence. It is possible to generate an error component occurring due to a step driving direction by calculating, for example, the average value of measurement data for each step driving direction with respect to the measurement data of the first substrate. Such an error component occurring due to a step driving direction is removed from the measurement data of each shot region of the measurement data of the first substrate. This makes it possible to obtain correction measurement data indicating the substrate error component common to the shot layouts from which the error component unique to the shot layouts is removed.

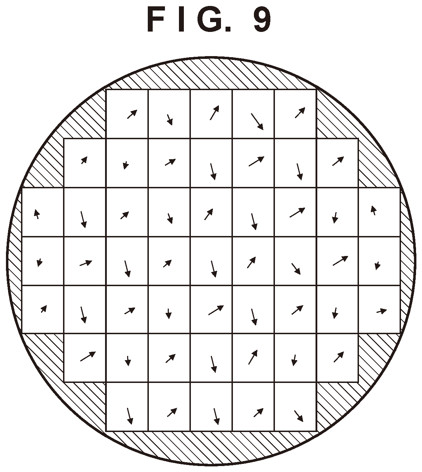

Another error component unique to a shot layout sometimes occurs due to a scan driving direction of the substrate stage 6 at the time of exposure processing by the exposure apparatus 204. This error component can occur in a step-and-scan exposure apparatus (scanner) that performs exposure while synchronously driving the reticle stage 2 and the substrate stage 6. Fig. 8 shows an example of a scan driving direction at the time of exposure processing by the exposure apparatus 204. Fig. 9 shows an example of an error component occurring due to a scan driving direction, showing how a characteristic error component occurs due to a scan driving direction. Such an error component is mainly caused by the hold characteristic of the reticle 1, the drive characteristic of the reticle stage 2, the drive characteristic of the projection optical system 3, and the drive characteristic of the substrate stage 6.

A scan driving direction at the time of exposure processing is determined by a predetermined shot layout and a shot exposure sequence (the exposure sequence of a plurality of shot regions). For example, the storage device of the controller 16 holds the shot layout, the shot exposure sequence, and the scan driving directions. It is possible to calculate an error component occurring due to a scan driving direction by calculating the average value of measurement data for each scan driving direction with respect to the measurement data of the first substrate based on the scan driving direction in each shot region. Such an error component occurring due to a scan driving direction is removed from the measurement data of each shot of the substrate measurement data of the first substrate. This makes it possible to obtain correction measurement data indicating a substrate error component common to the shot layout from which the error component unique to the shot layout is removed.

A shot common shape component, an error component due to a step driving direction, and an error component due to a scan driving direction have been described above as error components unique to a shot layout. However, error components are not limited to them, and this technique can be applied to an error component common to substrates which is caused by a lithography process.

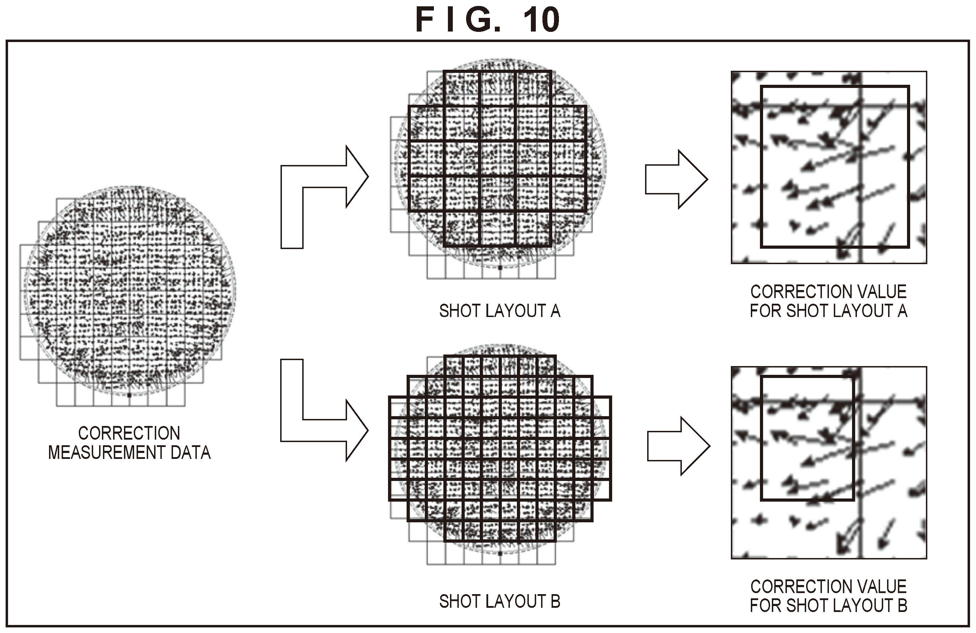

In step 103 (determination step), the information processing apparatus 206 determines a correction value to be provided to the exposure apparatus 204 based on the correction measurement data generated in step 102 and the shot layout of the second substrate when transferring a pattern onto the second substrate by using the exposure apparatus 204. The information processing apparatus 206 can be understood as an apparatus including a determination unit that executes step 103. Fig. 10 shows the processing of determining a correction value to be provided to the exposure apparatus 204 when transferring a pattern onto the second substrate by using the correction measurement data obtained by removing an error component unique to the shot layout from the measurement data of the first substrate.

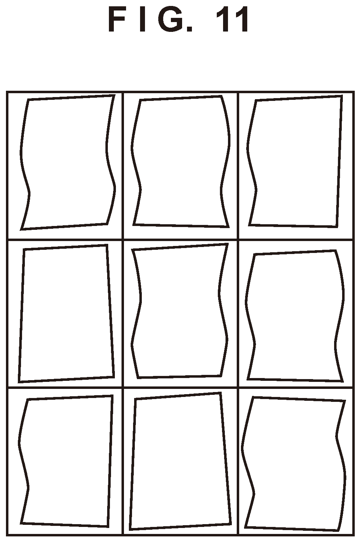

The substrate measurement data shown in Fig. 10 is an example of the correction measurement data obtained by removing the error component unique to the shot layout from the measurement data of the first substrate in step 102. The correction measurement data is provided to, for example, the controller 16 and can be held in the storage device of the controller 16 or the like. For example, the storage device of the controller 16 holds the shot layout of the second substrate as a processing target substrate. In a case where the second substrate as a processing target substrate is loaded into the exposure apparatus 204, and an exposure job is started, the controller 16 acquires the shot layout of the second substrate from the storage device of the controller 16 and extracts correction measurement data corresponding to each shot region from the correction measurement data. Subsequently, the controller 16 determines, for example, a correction value for correcting the shape of a shot region from the correction measurement data corresponding to the shot region for each shot region. As shown in Fig. 11, this correction value can include high-order shot region shape correction in the X and Y directions. The shot layout of the second substrate may be the same shot layout as that of the first substrate or a shot layout different from that of the first substrate. It is possible to flexibly and accurately determine correction values for various shot layouts based on correction measurement data. Correction values may be determined by the information processing apparatus 206, the exposure apparatus 204, or another apparatus. The apparatus that executes steps 101 and 102 may be the same as or different from the apparatus that executes step 103. It is possible to accurately correct a substrate error component independent of a shot layout by controlling exposure on the second substrate using the correction value determined in step 103.

In the step-and-scan exposure apparatus (scanner), it is possible to correct the shape of a shot region by, for example, changing the scanning speed of the substrate stage 6 with respect to the reticle stage 2 in accordance with a correction value during scanning exposure and changing the magnification of the projection optical system 3 during scanning exposure in accordance with a correction value. In the step-and-repeat exposure apparatus (stepper), it is possible to correct the shape of a shot region by driving an aspherically processed optical element of the projection optical system 3 during still exposure in accordance with a correction value.

A specific example of determining a correction value in step 103 will be described. A correction value for correcting the shape of a shot region can be determined through the fitting of a polynomial model as described below. Let Dx be a correction amount in the X direction at coordinates (x, y) in a shot region and Dy be a correction amount in the Y direction at coordinates (x, y) in the shot region. It is possible to determine correction coefficients k₁ to k₄₂ for each shot region by extracting measurement data corresponding to each shot region from correction measurement data and performing the fitting of the polynomial model. More specifically, for example, measurement positions in measurement data corresponding to each shot region are substituted from correction measurement data into x and y of equations (1), and measurement values are substituted into Dx and Dy of equations (1). The correction coefficients k₁ to k₄₂ can be determined by generating a matrix from m correction measurement data and inverting the matrix. Note that higher order coefficients may be added to the correction coefficients k₁ to k₄₂ or some of them may be removed in accordance with the correction ability of the exposure apparatus 204. $\begin{matrix}{D}_{x} = {k}_{1} + {k}_{3} x + {k}_{5} y \\ + {k}_{7} {x}^{2} + {k}_{9} xy + {k}_{11} {y}^{2} \\ + {k}_{13} {x}^{3} + {k}_{15} {x}^{2} y + {k}_{17} {xy}^{2} + {k}_{19} {y}^{3} \\ + {k}_{21} {x}^{4} + {k}_{23} {x}^{3} y + {k}_{25} {x}^{2} {y}^{2} + {k}_{27} {xy}^{3} + {k}_{29} {y}^{4} \\ + {k}_{31} {x}^{5} + {k}_{33} {x}^{4} y + {k}_{35} {x}^{3} {y}^{2} + {k}_{37} {x}^{2} {y}^{3} + {k}_{39} {xy}^{4} + {k}_{41} {y}^{5} \\ {D}_{y} = {k}_{2} + {k}_{4} y + {k}_{6} x \\ + {k}_{8} {y}^{2} + {k}_{10} xy + {k}_{12} {x}^{2} \\ + {k}_{14} {y}^{3} + {k}_{16} {xy}^{2} + {k}_{18} {x}^{2} y + {k}_{20} {x}^{3} \\ + {k}_{22} {y}^{4} + {k}_{24} {xy}^{3} + {k}_{26} {x}^{2} {y}^{2} + {k}_{28} {x}^{3} y + {k}_{30} {x}^{4} \\ + {k}_{32} {y}^{5} + {k}_{34} {xy}^{4} + {k}_{36} {x}^{2} {y}^{3} + {k}_{38} {x}^{3} {y}^{2} + {k}_{40} {x}^{4} y + {k}_{42} {x}^{5}\end{matrix}$$\left(\begin{matrix}{Dx}_{1} \\ {Dx}_{2} \\ {Dx}_{3} \\ ⋮ \\ {Dx}_{m}\end{matrix}\right) = \left(\begin{matrix}1 & {x}_{1} & {x}_{1} {y}_{1} & ⋯ & {y}_{1}^{5} \\ 1 & {x}_{2} & {x}_{2} {y}_{2} & ⋯ & {y}_{2}^{5} \\ 1 & {x}_{3} & {x}_{3} {y}_{3} & ⋯ & {y}_{3}^{5} \\ ⋮ & ⋮ & ⋮ & ⋱ & ⋮ \\ 1 & {x}_{m} & {x}_{m} {y}_{m} & ⋯ & {y}_{m}^{5}\end{matrix}\right) \left(\begin{matrix}{k}_{1} \\ {k}_{2} \\ {k}_{3} \\ ⋮ \\ {k}_{m}\end{matrix}\right)$

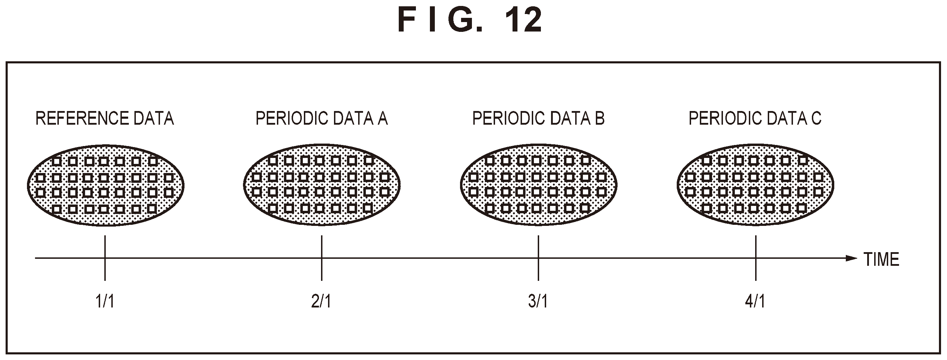

The following is a description of another specific example of the processing of removing an error component caused by unique exposure processing by the exposure apparatus 204 from the measurement data of the first substrate in step 102. In the above description, the error components caused by unique exposure processing by the exposure apparatus 204 include a shot common shape component, an error component due to a step driving direction, and an error component due to a scan driving direction. However, the measurement data of the first substrate may be periodically acquired, and the difference between the previous measurement data of the first substrate and the current measurement data of the first substrate may be calculated as an error component caused by unique exposure processing by the exposure apparatus 204. Calculating such an error component and removing it from measurement data can correct an error component caused by a temporal change in the substrate holding mechanism 5. Fig. 12 shows how the measurement data of the first substrate is acquired as reference data, and the measurement data of the first substrate is acquired three times thereafter, for example, every month as periodic data A, B, and C. For example, calculating a correction value based on the difference between reference data and the period data A can correct the error component caused by a temporal change in the substrate holding mechanism 5 in the interval between the acquisition time of the reference data and the acquisition time of the periodic data A. Calculating a correction value based on the difference between the reference data and the period data C can correct the error component caused by a temporal change in the substrate holding mechanism 5 in the interval between the acquisition time of the reference data and the acquisition time of the periodic data C.

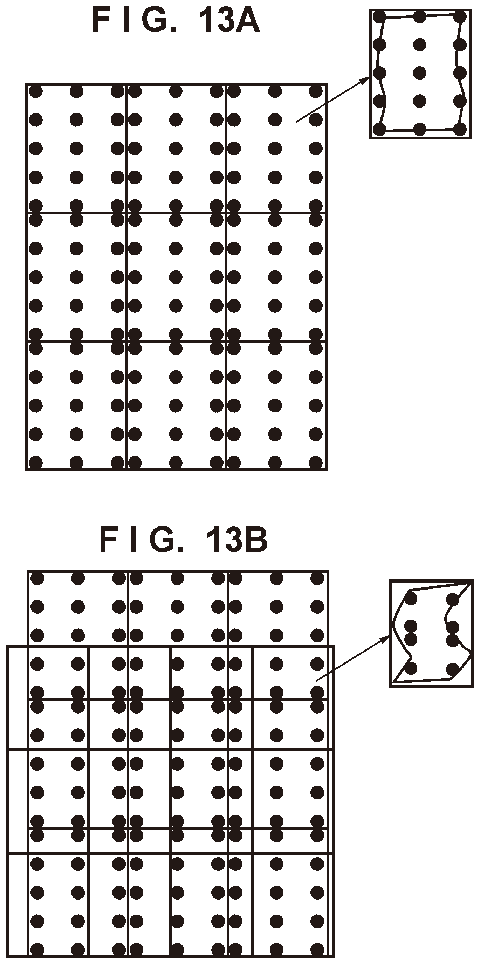

The following is a description of another specific example of the processing of determining a correction value in accordance with the shot layout of the second substrate in step 103. The density of correction measurement data sometimes varies at the time of determining a correction value in accordance with the shot layout of the second substrate depending on the arrangement of measurement points at the time of measurement of the first substrate. Such a case will be described with reference to Figs. 13A and 13B. Each black circle indicates measurement data. Each thin line rectangle indicates the shot layout of a substrate. Each thick line rectangle indicates the shot layout of the second substrate. Fig. 13A shows the shot layout of the first substrate. Fig. 13B shows the shot layout of the second substrate. As shown in Fig. 13A, on the first substrate, measurement data (measurement points) are arranged up to the ends of the shot region. If the shot layout of the second substrate is similar to that of the first substrate, a correction value can be properly determined. However, as shown in Fig. 13B, the shot layout of the second substrate may not include any measurement data (measurement points) at the ends of the shot region, resulting in obtaining an excessive correction value. In such a case, in a generating step of step 102, correction measurement data is preferably generated by interpolating the data obtained by removing a component dependent on the shot layout from the measurement data acquired in step 101.

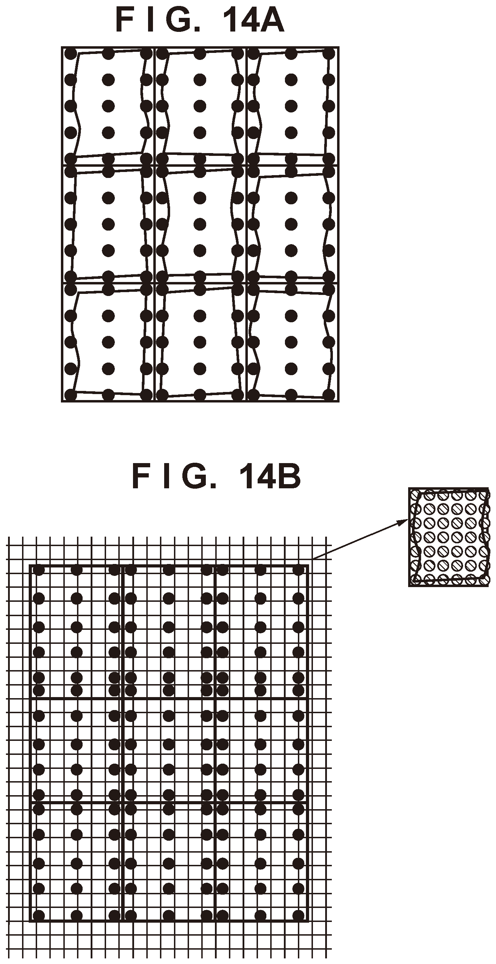

Fig. 14A exemplarily shows the measurement points of the shot layout of the first substrate. In step 102, correction measurement data at each measurement point can be generated in accordance with the method described above. In step 102, the information processing apparatus 206 can define pseudo measurement points (intersecting points) at a pitch as fine as, for example, 1 mm, as shown in Fig. 14B. In addition, in step 102, the information processing apparatus 206 calculates the correction measurement data of the pseudo measurement points based on the correction measurement data at the measurement points in Fig. 14A by interpolation. In step 103, the information processing apparatus 206 determines correction values by extracting measurement values from the correction measurement data at the measurement points and the pseudo measurement points in accordance with the shot layout of the second substrate. This makes it possible to determine correction values without causing variation in the density of measurement data.

The exposure apparatus 204, instead of the substrate measurement device 205, may generate the measurement data of the first substrate by using the alignment scope 15 of the exposure apparatus 204. In addition, the measurement data of the first substrate may be marks for the measurement of absolute positional shift amounts, such as alignment marks arranged on a substrate, instead of marks for the measurement of relative positional shift amounts, such as box-in-box marks.

The measurement data of the first substrate may be, for example, the positions (heights) of a plurality of portions of the substrate in the Z direction which are obtained by measuring the substrate with the focus sensor 11 of the exposure apparatus 204 instead of the positional shift amounts of the plurality of portions of the substrate in the X and Y directions. In the same way that unique error components in the measurement data of the first substrate are positional shift amounts in the X and Y directions, for example, a shot common component in the Z direction (a component common to a plurality of shot regions) can be an error component caused by unique exposure processing by the exposure apparatus 204. Correction values corresponding to the shot layout of the second substrate can include the rotation correction value θX around the X-axis and the rotation correction value θY around the Y-axis. In the step-and-scan exposure apparatus, these values may correct θX and θY for each position of the stage in the scanning direction during scanning exposure on each shot region.

A pattern transfer method according to one embodiment is configured to determine correction values based on the measurement data of the first substrate onto which a pattern is transferred by the exposure apparatus 204 and the shot layout of the second substrate in accordance with the determination method shown in Fig. 3. The pattern transfer method can include a transfer step of transferring a pattern onto the second substrate while correcting the exposure apparatus 204 in accordance with the above correction values.

An article manufacturing method according to one embodiment can include a transfer step of transferring a pattern onto the second substrate by the above transfer method and a processing step of obtaining an article by processing the second substrate onto which the pattern has been transferred in the transfer step. The processing step can include, for example, a step of developing the second substrate onto which the pattern has been transferred in the transfer step and other known steps. Other known steps include etching, resist removal, dicing, bonding, and packaging. This article manufacturing method can manufacture an article with higher quality than that of an article manufactured by conventional methods.

### (Other Embodiments)

The present invention can be implemented by processing of supplying a program for implementing one or more functions of the above-described embodiments to a system or apparatus via a network or storage medium, and causing one or more processors in the computer of the system or apparatus to read out and execute the program. The present invention can also be implemented by a circuit (for example, an ASIC) for implementing one or more functions.

While the preferred embodiment of the present invention has been described, the present invention is not limited to these embodiments and can be variously modified and changed within the scope of the invention.

This application claims the benefit of Japanese Patent Application No. 2023-172129 filed on October 3, 2023, which is hereby incorporated by reference herein in its entirety.

## Claims

1. A determination method comprising:
a generation step of generating correction measurement data by removing a component dependent on an array of a plurality of shot regions of a first substrate onto which a pattern is transferred by a lithography apparatus from measurement data of the first substrate; and
a determination step of determining a correction value to be provided to the lithography apparatus when transferring a pattern onto a second substrate by using the lithography apparatus based on the correction measurement data and an array of a plurality of shot regions of the second substrate.

2. The determination method according to claim 1, wherein the measurement data includes measurement data concerning positions of a plurality of marks of the first substrate.

3. The determination method according to claim 1, wherein the component dependent on the array includes a component common to the plurality of shot regions of the first substrate.

4. The determination method according to claim 1, wherein the component dependent on the array includes an average of measurement data of each of the plurality of shot regions of the first substrate.

5. The determination method according to claim 1, wherein the lithography apparatus is an exposure apparatus, and
the component dependent on the array includes a component dependent on a step driving direction between shot regions of the first substrate.

6. The determination method according to claim 1, wherein the lithography apparatus is a scanning exposure apparatus, and
the component dependent on the array includes a component dependent on a scanning direction of each of the plurality of shot regions of the first substrate in scanning exposure.

7. The determination method according to claim 1, wherein the component dependent on the array includes a difference between previous measurement data of the first substrate and current measurement data of the first substrate.

8. The determination method according to any one of claims 1 to 7, wherein the measurement data includes measurement data of an overlay error.

9. The determination method according to claim 1, wherein the measurement data includes measurement data concerning heights of a plurality of portions of the first substrate.

10. The determination method according to any one of claims 1 to 9, wherein in the generation step, the correction measurement data is generated by interpolating data obtained by removing the component dependent on the array from the measurement data.

11. The determination method according to any one of claims 1 to 10, further comprising a step of obtaining the measurement data by measuring the first substrate.

12. A pattern transfer method comprising:
a step of determining a correction value by a determination method defined in any one of claims 1 to 11; and
a step of transferring a pattern onto the second substrate while correcting the lithography apparatus based on the correction value.

13. An article manufacturing method comprising:
a step of transferring a pattern onto the second substrate by a pattern transfer method defined in claim 12; and
a step of obtaining an article by processing the second substrate onto which the pattern is transferred.

14. A program causing a computer to execute a determination method defined in any one of claims 1 to 11.

15. An information processing apparatus comprising:
a generating unit configured to generate correction measurement data by removing a component dependent on an array of a plurality of shot regions of a first substrate onto which a pattern is transferred by a lithography apparatus from measurement data of the first substrate; and
a determination unit configured to determine a correction value to be provided to the lithography apparatus when transferring a pattern onto a second substrate by using the lithography apparatus based on the correction measurement data and an array of a plurality of shot regions of the second substrate.

16. A lithography system including a lithography apparatus, the system comprising:
a generating unit configured to generate correction measurement data by removing a component dependent on an array of a plurality of shot regions of a first substrate onto which a pattern is transferred by a lithography apparatus from measurement data of the first substrate; and
a determination unit configured to determine a correction value to be used when transferring a pattern onto a second substrate based on the correction measurement data and an array of a plurality of shot regions of the second substrate,
wherein a pattern is transferred onto the plurality of shot regions of the second substrate by the lithography apparatus while controlling the lithography apparatus in accordance with the correction value.
